# EUROPEAN PATENT APPLICATION

(11) **EP 4 794 511 A1**
(43) Date of publication of application: **19.08.2026**
(21) Application number: 25213362.4
(22) Date of filing: 04.11.2025
(51) Int. Cl.: H10W 40/20, H10W 40/25, H10W 40/77, H10W 90/00, H10W 40/73

(54) **HEAT FLOW CONTROL DEVICE OF SEMICONDUCTOR PACKAGE, SEMICONDUCTOR PACKAGE INCLUDING THE HEAT FLOW CONTROL DEVICE, AND SEMICONDUCTOR MODULE INCLUDING THE SEMICONDUCTOR PACKAGE**

(30) Priority: 13.02.2025 KR 20250019015; 27.03.2025 KR 20250039892; 27.03.2025 KR 20250039893
(71) Applicant: LX Semicon Co., Ltd., Daejeon 34027 (KR)
(72) Inventor: HAN, Young Soo, 34027 Daejeon (KR); LEE, Sang Rae, 34027 Daejeon (KR); LEE, Yun Tae, 34027 Daejeon (KR); RA, Se Woong, 34027 Daejeon (KR); KIM, Jin Gyu, 34027 Daejeon (KR)
(74) Representative: Goddar, Heinz J.

(57) **Abstract**

The embodiment relates to a heat flow control device of a semiconductor package, a semiconductor package including the heat flow control device, and a semiconductor module including the semiconductor package.

The heat flow control device according to the embodiment may include a heat flow control body and a heat flow control layer disposed on a side of the heat flow control body, and the heat flow control layer may include a plating layer.

The heat flow control layer may include a first heat flow control layer and a second heat flow control layer sequentially disposed on a side of the heat flow control body.

## Description

### PRIORITY CLAIM

This application claims the priorities of Korean patent application KR 10-2025-0019015 filed on February 13, 2025, Korean patent application KR 10-2025-0039892 filed on March 27, 2025 and Korean patent application KR 10-2025-0039893 filed on March 27, 2025, which are incorporated herein by reference.

### BACKGROUND

### Field of the Disclosure

This disclosure generally relates to a heat flow control device for use in a semiconductor package. This disclosure further provides a semiconductor package including the heat flow control device, and a semiconductor module including the semiconductor package.

### Description of the Background

As the performance of electric and electronic products progresses, a semiconductor package in which a plurality of semiconductor devices are disposed on a semiconductor package substrate is utilized, and the semiconductor package has an advantage of efficiently using the mounting area of the semiconductor devices and transmitting high-speed signals through a short signal transmission path between the semiconductor devices.

These semiconductor packages are used in various fields, such as smart phones, personal digital assistants, high-performance servers, network systems, computers, monitors, tablets, laptops, televisions, video games, smart watches, automotive, or IoT.

For example, one of the industries in the semiconductor market that has been rapidly growing recently is the data sensor technology field and data centers where AI (Artificial Intelligence) semiconductors are used. The use of AI semiconductors consumes comparably high power and is increasing. There is thus an interest in improving the heat dissipation technology of semiconductor packages. Accordingly, research to secure new heat dissipation technology is currently conducted in the semiconductor and semiconductor package markets in the data center sector, which currently experience high growth rates.

Further, HBM (High Bandwidth Memory) conventionally used for servers is now increasingly used in personal PCs and smartphones due to the expansion of the on-device AI market. Yet, HBM may be more vulnerable to heat in those use cases because the HBM is closer to the application processor (AP) in a PC or smartphone with a small form factor. This is specifically true in architectures where multiple DRAMs are vertically stacked or combined into a single package. Therefore, it is important to stably manage the heat generation problem to facilitate the use HBM in personal electronic devices, such as PCs and smartphones.

Furthermore, 1200V, 200A high-voltage/high-power SiC power convertor modules are used to improve the performance of hybrid and electric vehicles and for autonomous vehicles. During the operation of these high-performance electric vehicles, the operating temperature of power semiconductor devices is in the range of 300°C or even higher on average, and the maximum operating temperature in an ultra-high temperature usage state may be as high as 350°C to 700°C. In such the ultra-high temperature, high voltage, and high current operating environments, bonding materials themselves may melt, and a heat trap phenomenon may occur due to pores existing in the bonding area. The heat trap phenomenon may cause a thermal runaway such that the power semiconductor module may rapidly deteriorate the life of the power semiconductor module. This thermal runaway situation may lead to the destruction of the power semiconductor device, which may have a serious impact on the safety of the driver.

Accordingly, various heat dissipation components and heat dissipation modules, such as heat sinks, heat dissipation plates, heat pipes, vapor chambers, etc. are being studied to solve the heat generation problem of electronic devices such as AI semiconductors and power semiconductor modules.

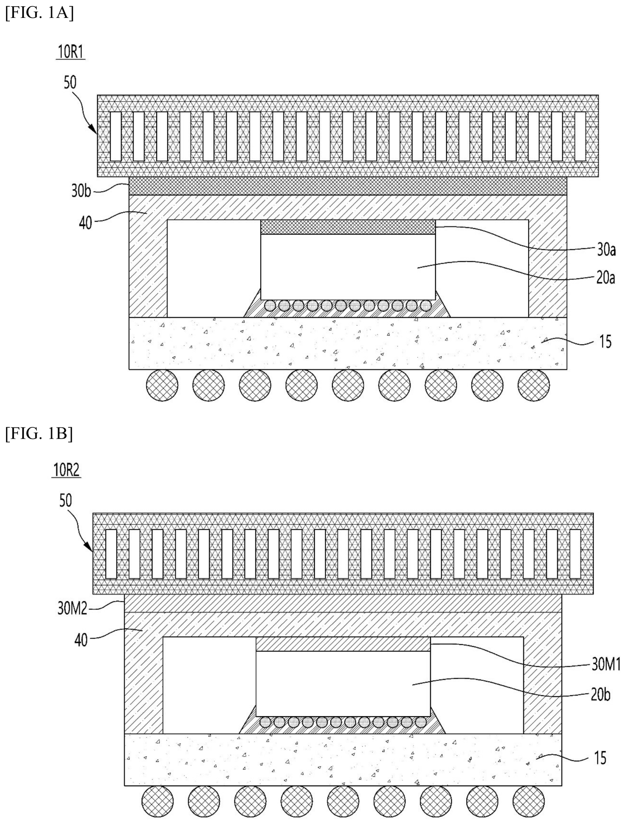

FIG. 1A is a cross-sectional view of a semiconductor package (10R1) according to a first comparative example.

In the semiconductor package (10R1) of the first comparative example, a heat dissipation plate (40) in the form of a metal lid is disposed on the first electronic device (20a) to release heat generated from the first electronic device (20a) upwardly. And the first electronic device (20a) and the heat dissipation plate (40) may be bonded by a first adhesive layer (30a) of a polymeric material. In addition, a heat sink (50) may be disposed on the heat dissipation plate (40), and the heat dissipation plate (40) and the heat sink (50) may be bonded by a second adhesive layer (30b) of a polymeric material.

However, the first adhesive layer (30a) and the second adhesive layer (30b) of the polymeric material have low thermal conductivity, so that the heat generated from the first electronic device (20a) may not spread and is concentrated in the center, which has a problem in that the heat dissipation efficiency is reduced. Accordingly, the semiconductor package (10R1) of the first comparative example had a problem in that the driving power was lowered to lower the temperature by itself as the temperature of the first electronic device (20a) increased, and the performance was lowered to 30% or less.

Next, FIG. 1B is a cross-sectional view of the semiconductor package (10R2) according to the second comparative example.

Unlike the first comparative example, the semiconductor package (10R2) of the second comparative example was studied to include a metal material such as a metal TIM (Thermal Interface Material) in the first metal adhesive layer (30M1) and the second metal adhesive layer (30M2) in order to improve the efficiency of transferring heat generated from the second electronic device (20b) upward (y direction).

However, if there is a difference in the coefficient of thermal expansion between the heat dissipation plate (40) and the second electronic device (20b) or a difference in the coefficient of thermal expansion between the heat dissipation plate (40) and the heat sink (50), warpage may occur when the temperature of the second electronic device (20b) increases rapidly, and as a result, cracks and voids may occur in the first metal adhesive layer (30M1) or the second metal adhesive layer (30M2), resulting in delamination.

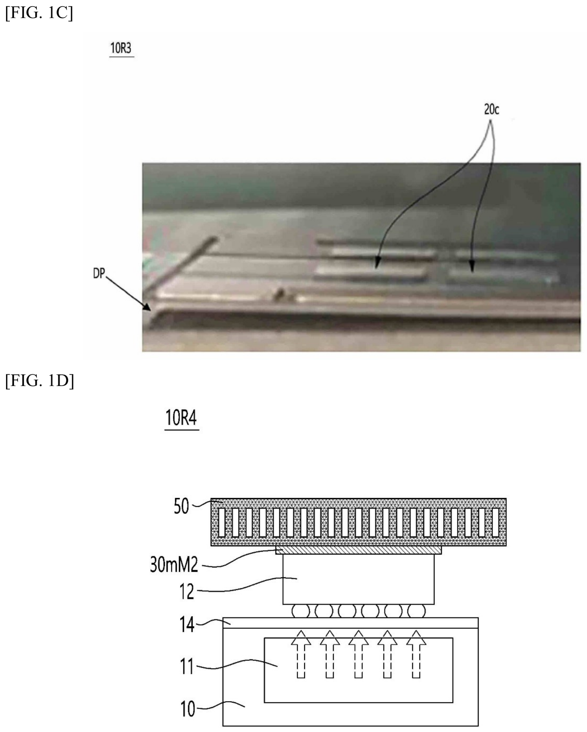

For example, FIG. 1C is a photograph showing delamination (DP) in a semiconductor package (10R3) according to the third comparative example.

For example, as in FIG. 1C, when the temperature of the electronic devices (20c) increases rapidly, warpage may occur due to the difference in the coefficient of thermal expansion of the adjacent components, and cracks and voids may occur in the metal TIM, causing delamination.

Accordingly, in high-performance semiconductors such as AI semiconductors or power semiconductor modules, metal adhesive layers such as metal TIM are used to efficiently transfer heat generated from electronic devices upward (y direction), but there is a problem of technical contradiction in that delamination may occur in the metal adhesive layer due to the difference in the thermal expansion coefficient between adjacent materials.

In addition, in recent smartphone technology, memory devices such as HBM are disposed in a SIP (System In Package) form that is combined with the application processor (AP) in a single package. Therefore, since the memory devices vulnerable to heat are adjacent to logic chips in a narrow space, if the flow of heat is not controlled, the heat from the logic chip may damage the HBM and the reliability may drop.

Recently, semiconductor packages are becoming larger in size as their functions increase, and AP or SOC (chips that include other functional chips in addition to APs) are also generating more heat as their performance improves. For example, HBMs used for servers may be vulnerable to heat because HBMs is closer to the application processor (AP) in PCs or smartphones with a small form factor in a structure where multiple DRAMs are vertically stacked, or combined into a single package. Therefore, in order for high-performance semiconductor devices such as HBMs to be applied to personal electronic devices such as PCs or smartphones, it is important to stably manage the heat generation problem. However, in the conventional technology, there is no solution from the perspective of heat flow control to the problem that the heat generated from logic chips, etc. causes damage to memory devices such as HBMs during the process of moving to a heat sink or vapor chamber, thereby lowering reliability.

For example, FIG. 1D is a cross-sectional view of a semiconductor package (10R4) according to the fourth comparative example.

The semiconductor package (10R4) according to the fourth comparative example may include a first semiconductor device (11) disposed on a first substrate (10) and a second semiconductor device (12) disposed on a conductive layer (14) on the first substrate (10).

The first substrate (10) may include at least one of a plurality of insulating layers, wiring layers, and via electrodes. The first semiconductor device (11) may include an active device and/or a passive device. For example, the active device may be a semiconductor chip in the form of an integrated circuit (IC) in which hundreds to millions of devices (e.g. transistors) are integrated into one chip.

In addition, the first semiconductor device (11) may include a logic chip. For example, the logic chip may be an application processor (AP) chip including at least one of a central processor (CPU), a graphics processor (GPU), a digital signal processor, an encryption processor, a microprocessor, a microcontroller, or an analog-to-digital converter, an application-specific IC (ASIC), or a system on chip (SoC) including a specific combination of these.

Alternatively, the second semiconductor device (12) may be a memory chip, etc. For example, the memory chip may be a stacked memory such as HBM. In addition, the memory chip may be a volatile memory (e.g., DRAM), a non-volatile memory (e.g., ROM), a flash memory, etc.

According to the semiconductor package (10R4) according to the fourth comparative example, the heat generated from the first semiconductor device (11) such as the logic chip may be transferred to the heat sink or vapor chamber, causing damage to the second semiconductor device (12) which is a memory device such as HBM, and thus reducing reliability. There is no solution to this problem from the viewpoint of heat flow control. In the past, the heat generated from the first semiconductor device (11) was not a major problem, But as the performance of the first semiconductor device (11) such as ASIC or SoC (System on chip) s improved, the heat generated from the first semiconductor device (11) causes thermal damage to the second semiconductor device (12) such as a memory chip, and thus heat flow management becomes important.

### SUMMARY

Accordingly, one of the technical objects of this disclosure is to solve the problem of a technical contradiction in that heat generated from an electronic device is needed to be transferred upward (y direction) while delamination occurs due to a difference in the coefficient of thermal expansion of adjacent materials. Put different, one of the technical problems that may be addressed using this disclosure relates to the risk of delamination at bonding interfaces in semiconductor packages. In particular, when heat generated from an electronic device must be efficiently transferred upward to a heat dissipation component, mechanical stress may arise due to differences in the coefficients of thermal expansion (CTE) between the bonded materials. This mismatch can lead to structural failures such as cracks or separation at the interface, compromising the thermal and mechanical integrity of the semiconductor module.

Another one of the technical objects of this disclosure is to solve the problem of heat generated from a logic chip, etc. causing damage to a memory device, such as an HBM, and thus reducing reliability in the process of transferring to a heat sink or vapor chamber, by controlling the heat flow. Put different, another technical problem that may be addressed using this disclosure concerns the uncontrolled lateral transfer of heat from active devices (such as for example high-performance logic devices) to nearby heat-sensitive components (such as for example high-bandwidth memory (HBM)). During operation, this unintended heat flow can cause thermal stress or damage to heat-sensitive devices positioned adjacent to the active device(s), ultimately reducing the reliability and operational stability of a semiconductor module.

The technical objects of this disclosure are not limited to those described above and include those that may be understood through the description of the invention.

This disclosure suggests - but is not limited to - the following aspects that address at least one of the technical objects.

A first aspect of this disclosures provides a heat flow control layer (150) having lower thermal conductivity that is disposed on at least one (lateral) side of the heat flow control body (110) that is adjacent (in terms of at least one of or both of structural positioning and heat flow direction) to a heat-sensitive device or component, such as a memory device. That is, "adjacent" may refer not only to physical proximity within the architecture of a semiconductor package or semiconductor module, but also to the path along which heat would otherwise flow toward the heat-sensitive device or component. This disclosure also contemplates the provision of individual heat flow control layers (150) on one or more (lateral) sides of the heat flow control body (110), depending for example on the location and distribution of heat-sensitive devices in the semiconductor package or the semiconductor module. The provision of a heat flow control layer (150) on at least one (lateral) side of the heat flow control body (110) may effectively minimize heat flow in the second direction (toward the memory device) while maximizing the first direction heat flow (upward in y direction). This may reduce damage to the heat-sensitive devices or components and improves overall package reliability.

A second aspect of this disclosure provides an uneven portion (110R) formed on the upper surface of the heat flow control body (110). The uneven portion (110R) may refer, for example, to at least some portion of the upper surface of the heart flow control body (110) to be interfacing with a heat dissipation device (230) and that has a roughened surface. The uneven portion (110R) may improve the bonding interface between the heat flow control body (110) and the heat dissipation device (230), such as a vapor chamber. The increased surface roughness of the upper surface may enlarge the adhesive contact area and enhance the mechanical interlocking with an adhesive layer or bonding material. This may increase adhesive strength at the bonding interface, reduce the possibility of peeling or delamination. Thereby bonding reliability may be improved and heat dissipation efficiency in the first direction (upward in y direction) can be maximized.

A third aspect of this disclosure provides a configuration in which a plurality of spaced first connecting members (112), such as solder balls, are disposed under the heat flow control body (110) to address the issue of delamination caused by thermal expansion mismatch at the bonding interface. The spatial separation of the connecting members (112) allows for dispersion of thermal expansion stress that may otherwise accumulate during operation due to differences in the coefficients of thermal expansion (CTE) between adjacent materials. This structural arrangement may prevent the occurrence of cracks or voids in the bonding layer and thereby enhance bonding reliability and heat dissipation efficiency in the semiconductor package.

Example implementations according to embodiments of the first aspect relate to a heat flow control device for use in a semiconductor package that may include a heat flow control body (110) having a lower surface that is to face a heat generating semiconductor device and a heat flow control layer (150) disposed on a lateral side of the heat flow control body (110) that is to face a heat-sensitive semiconductor device, wherein heat flow control layer (150) has a lower thermal conductivity than the heat flow control body (110).

Example implementations according to embodiments of the second aspect relate to a heat flow control device for use in a semiconductor package. The heat flow control device may include a heat flow control body (110) and uneven portion (110R) on an upper surface of the heat flow control body (110). In some example implementation, the upper surface of the heart flow control body (110) may have an average roughness (Ra) in the range of 0.05 *µ*m (inclusive) to 0.8 *µ*m (inclusive), preferably in the range of 0.1 *µ*m (inclusive) to 0.5 *µ*m (inclusive), but the second aspect is not limited to this range only

According to an example implementation, a roughness of the upper surface of the heat flow control body (110) may be greater than the roughness of the inclined surface (110S) of one side of the heat flow control body (110).

The heat flow control body (110) may have a lower surface that is to face a heat generating semiconductor device.

The heat flow control body (110) may have a lower surface that is to face a heat generating semiconductor device. The heat flow control device may further include a heat flow control layer (150) disposed on a lateral side of the heat flow control body (110) that is to face a heat-sensitive semiconductor device, wherein heat flow control layer (150) has a lower thermal conductivity than the heat flow control body (110). Optionally, the heat flow control layer (150) may include a plating layer.

Example implementations according to embodiments of the third aspect relate to a heat flow control device for use in a semiconductor package that may include a heat flow control body (110) having a lower surface that is to face a heat generating semiconductor device and a plurality of spaced first connecting members (112) disposed on the lower surface of the heat flow control body (110).

The embodiments of the disclosure implementing the first aspect may be readily combined with the embodiments of the disclosure implementing the second aspect and/or third aspect. The embodiments of the disclosure implementing the second aspect may be readily combined with the embodiments of the disclosure implementing the third aspect.

The embodiments of the heat flow control device according to the first, second and third aspects may have the following additional optional features.

As noted above, the of the heat flow control device may have a heat flow control layer (150). The thermal conductivity of the heat flow control layer (150) may be at least 75 W/(m·K) lower than that of the heat flow control body (110), preferably at least 150 W/(m·K) lower than that of the heat flow control body (110), more preferably at least 250 W/(m·K) lower than that of the heat flow control body (110).

The heat flow control layer (150) may include a first heat flow control layer (151) and a second heat flow control layer (152) sequentially disposed on the lateral side of the heat flow control body (110).

The first heat flow control layer (151) may include a nickel-based plating layer, and the second heat flow control layer (152) may include a palladium-based plating layer.

The second heat flow control layer (152) may include an electroless nickel immersion gold layer (ENIG) or an electroless nickel electroless palladium immersion gold layer (ENEPIG).

Optionally, a ceramic or oxide-based coating layer may disposed on the heat flow control layer (150) or the second heat flow control layer (152).

The one side of the heat flow control body (110) that is to face a heat-sensitive semiconductor device may have an inclined surface (110S). In some example implementation, an angle φ may defined as the interior angle formed between the lower surface of the heat flow control body (110) and the inclined surface (110S). The interior angle φ is measured within the volume of the heat flow control body. The interior angle φ may be set within a range of approximately 45° to 85°, and preferably between 60° and 80°.

In cross section (e.g. view on the x-y plane), the heat flow control body (110) may have a first width (W1) at a first vertical position, and a second width (W2) smaller than the first width (W1) at a second vertical position that is above the first vertical position. For example, the second vertical position may be farther away from the lower surface of the heat flow control body (110) than the first vertical position.

The heat flow control device may include a lower protective layer (120) disposed on the lower surface of the heat flow control body (110). The plurality of spaced first connecting members (112) of the heat flow control device may be disposed the lower protective layer (120) of the heat flow control body (110).

The lower protective layer (120) may be a solder resist, and the first connecting members (112) may include or are realized by means of solder balls.

The heat flow control body (110) may include an uneven portion (110R) on its upper surface.

In some example implementation, the upper surface of the heat flow control body (110) may have an average roughness (Ra) in the range of 0.1 *µ*m (inclusive) to 0.5 *µ*m (inclusive).

The surface roughness of the upper surface of the heat flow control body (110) may be, for example, greater than the roughness of the inclined surface (110S) of one side of the heat flow control body (110).

In addition, embodiments of the first aspect may relate to the semiconductor package that may include a first semiconductor device (211) disposed on a first package substrate (210a), a heat flow control device (101, 102) disposed on the first semiconductor device (211), and a second semiconductor device (212) disposed spaced apart from the first heat flow control device (101, 102) at a lateral side of the first heat flow control device (101, 102).The heat flow control device (101, 102) may be any of the heat flow control devices described herein above or below implementing the first aspect of the disclosure.

Further, embodiments of the second aspect may relate to the semiconductor package that may include a first semiconductor device (211) disposed on a first package substrate (210a), a heat flow control device (101, 102) that is disposed over the first semiconductor device (210a), and a heat dissipation device (230) disposed on the heat flow control device (101, 102), wherein the heat dissipation device (230) is in intimate contact with the upper surface of the heat flow control body (110) of the heat flow control device (101, 102). The heat flow control device (101, 102) may be any of the heat flow control devices described herein above or below implementing the second aspect of the disclosure.

Further, embodiments of the third aspect may relate to the semiconductor package that may include a first semiconductor device (211) disposed on a first package substrate (210a), a heat flow control device (101, 102) that is disposed over the first semiconductor device (210a), wherein the heat flow control body (110) has a lower surface on which a plurality of spaced first connecting members (112) are disposed to provide thermal interfacing between the first semiconductor device (210a) and the heat flow control device (101, 102). The heat flow control device (101, 102) may be any of the heat flow control devices described herein above or below implementing the third aspect of the disclosure.

The embodiments of the semiconductor package according to the first and second aspects may have the following additional optional features.

The heat dissipation device (230) may be disposed on the heat flow control device (101, 102). Optionally, the heat dissipation device (230) may be further also disposed on the second semiconductor device (212). The heat dissipation device (230) is in intimate contact with the upper surface of the heat flow control body (110) of the heat flow control device (101, 102) and optionally in intimate contact with an upper surface of the second semiconductor device (212), when present.

The upper surface of the heat flow control body (110) may be bonded to a lower surface of the heat dissipation device (230) by an adhesive layer (216). For example, the adhesive layer (216) may be a thermal interface material (TIM) layer.

Optionally, an upper surface of the second semiconductor device (212) may be bonded to a lower surface of the heat dissipation device (230) by an adhesive layer (218). For example, the adhesive layer (218) may be a thermal interface material (TIM) layer.

The heat flow control device (101, 102) may be disposed to vertically overlap the first semiconductor device (211).

The heat flow control layer (150) may be disposed on the side of the heat flow control body (110) which is adjacent to the second semiconductor device (212).

The semiconductor module (1000) according to an exemplary embodiment of this disclosure may include any one of the semiconductor packages described herein above or below.

The heat flow control device for use in a semiconductor package according to the embodiments of this disclosure may solve the technical problem of delamination occurring due to the difference in thermal expansion coefficients of adjacent materials while ensuring transfer of heat generated from the electronic device upward (y direction).

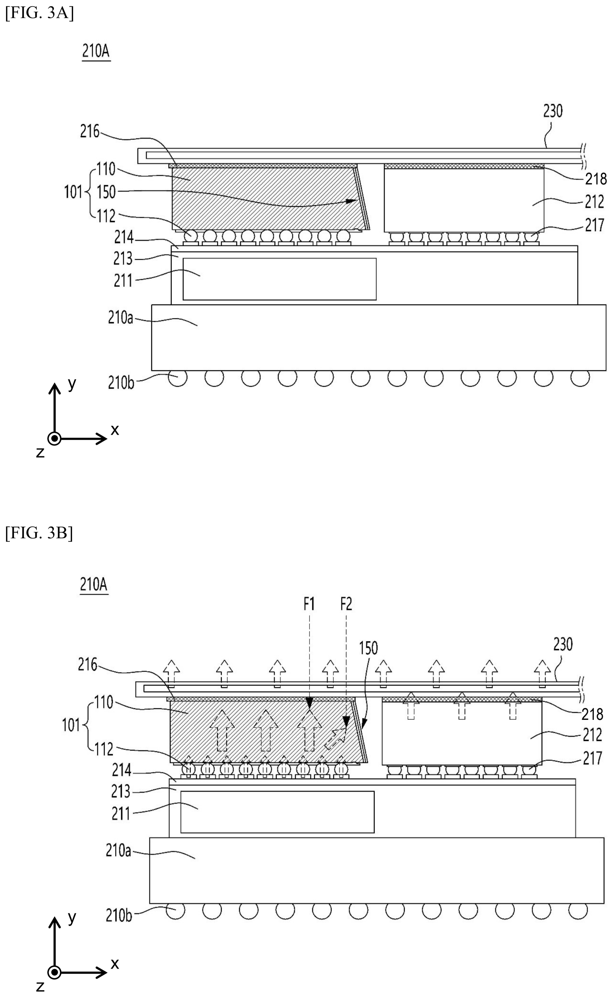

For example, referring to the example embodiment in FIG. 3B, the first heat flow control device (101) may include a plurality of spaced first connecting members (112) under the heat flow control body (110), thereby dispersing thermal expansion stress caused by heat generated from the first semiconductor device (211). This contributes to preventing delamination due to cracks or voids in the first connecting member (112). Hence, the technical effect of improving heat dissipation efficiency and bonding reliability at the bonding portion is achieved in this example embodiment.

For example, when the first connecting member (112) of the heat flow control device (101) are solder balls, there is a stress dissipation effect due to mutual separation of the solder balls. Accordingly, by dispersing thermal expansion stress caused by heat generated from the first semiconductor device (211), a delamination due to cracks or voids may be prevented. Hence, the technical effect of improving heat dissipation efficiency and bonding reliability at the bonding portion is achieved in this example embodiment.

Furthermore, in comparative technology as for example shown in FIG. 1Bthe TIM material (30M1, 30M2) is applied to the entire surface at the joint interface between the heat dissipation plate (40) and the heat sink (50), and the joint interface between the electronic device (20a, 20b) and the heat dissipation plate (40), respectively. Accordingly, the expansion and contraction amount due to the thermal stress generated according to the Coefficient of Thermal Expansion (CTE) difference increases, and the stress distribution effect at the joint interface(s) is low. Therefore, voids or cracks may occur, which may lower the reliability or heat dissipation efficiency at the joint interface(s).

In addition, controlling the flow of heat may solve the problem of memory devices such as HBM being damaged and the problem of reliability in the process of heat generated from a logic chip, etc. moving to a heat sink or vapor chamber, etc. being lowered.

For example, referring to the exemplary embodiment of this disclosure in FIG. 3B again, a first heat flow (F1) in the direction towards the upper side can be maximized by the first heat flow control device (101) that is disposed to vertically overlap the first semiconductor device (211). In addition, the second heat flow (F2) in a direction toward the second semiconductor device (212), such as HBM, can be minimized by the heat flow control layer (150). Accordingly, the technical effect of minimizing thermal damage to the second semiconductor device (212), such as a memory device, can be achieved and reliability is improved.

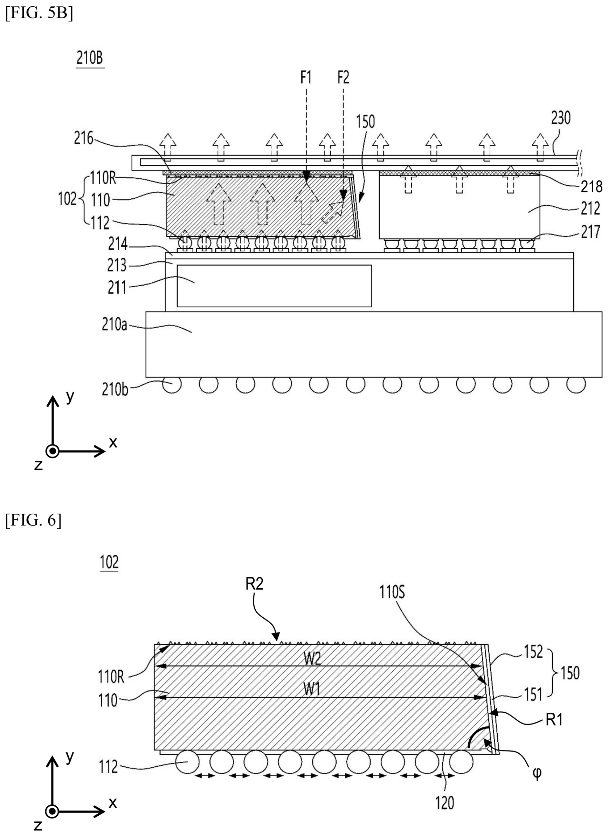

Further, referring to the exemplary embodiment of this disclosure in FIG. 5B, an uneven portion (110R) on the upper surface of the heat flow control body (110) of a heat flow control device (102) may be provided. This may improve the adhesive strength between the heat flow control device (102) and the heat dissipation device (230), such as the vapor chamber. Further, the adhesive area may be increased in the exemplary implementation shown in FIG. 5B. Hence, the technical effect of reducing the possibility of peeling and improving the bonding reliability can be achieved. Further, the heat dissipation efficiency toward the upper first direction heat flow (F1) may be maximized in the exemplary implementation shown in FIG. 5B.

The technical effects of the embodiment are not limited to those described herein above and may include those understood by the person skilled in the art studying this disclosure.

### BRIEF DESCRIPTION OF THE DRAWINGS

FIG. 1A is a cross-sectional view of a semiconductor package (10R1) according to the first comparative example.
FIG. 1B is a cross-sectional view of a semiconductor package (10R2) according to the second comparative example.
FIG. 1C is a photograph of a delamination problem (DP) in a semiconductor package (10R3) according to the third comparative example.
FIG. 1D is a cross-sectional view of a semiconductor package (10R4) according to the fourth comparative example.
FIG. 2A is a cross-sectional view of a semiconductor package module (1000) according to an embodiment.
FIG. 2B is a specific drawing of a semiconductor package module (1000) according to the embodiment illustrated in FIG. 2A.
FIG. 3A is a cross-sectional view of a first semiconductor package (210A) according to the first embodiment.
FIG. 3B is a specific drawing of a first semiconductor package (210A) according to the first embodiment illustrated in FIG. 3A.
FIG. 4 is a detailed drawing of a first heat flow control device (101) according to an embodiment.
FIG. 5A is a cross-sectional view of a second semiconductor package (210B) according to the second embodiment.
FIG. 5B is a detailed drawing of the second semiconductor package (210B) according to the second embodiment illustrated in FIG. 5A.
FIG. 6 is a detailed drawing of the second heat flow control device (102) according to the embodiment.
FIGS. 7A to 7C are exemplary drawings of semiconductor packages (210A3, 210A4, 210A5) according to the third to fifth embodiments.

### DETAILED DESCRIPTION

Hereinafter, the embodiments disclosed in this specification will be described in detail with reference to the attached drawings. The suffixes 'module' and 'part' used for components in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. Also, when an element such as a layer, region or substrate is referred to as being 'on' another element, this may include that it may be directly on the other element or that other intermediate elements may be present therebetween.

A first aspect of this disclosure provides a heat flow control layer (150) having lower thermal conductivity that is disposed on at least one (lateral) side of the heat flow control body (110) of a heat flow control device (100) that is provided adjacent to a heat-sensitive device or component, such as a memory device, within a semiconductor package or semiconductor module. The term "adjacent" is used herein to refer not only to physical proximity within the package/module architecture (e.g. in a horizontal direction (x)), but may encompass also thermal adjacency - that is, the direction along which heat generated by a heat source, such as a logic chip, would otherwise propagate toward the heat-sensitive component. This disclosure also contemplates the provision of individual heat flow control layers (150) on one or more lateral sides of the heat flow control body (110) of the heat flow control device (100), depending, for example, on the location and distribution of heat-sensitive components in the semiconductor package/semiconductor module.

In the structural configurations contemplated by this first aspect, the heat flow control body (110) of the heat flow control device (100) may be at least partially overlapping with the heat-generating device of a semiconductor package. The term "overlap" refers particularly to overlap in the vertical direction (i.e., along the upward direction (y) of heat dissipation within the package stack). However, the term "overlap" may also encompass both structural alignment in the physical layout and functional alignment with respect to the direction of dominant heat flow. That is, the heat flow control body (110) may be disposed directly above (y direction), or partially above, a heat-generating component (such as an application processor or SoC), so as to receive heat emitted during operation and direct it upward toward a heat dissipation device, such as a vapor chamber.

The positioning of the heat flow control body (110) (or the heat flow control device (100) in general) in vertical overlap with the heat source ensures that the upward-directed thermal path is efficient, while the laterally disposed heat flow control layer (150) acts to restrict unintended sideward heat propagation toward adjacent heat-sensitive components. As described in the example embodiments implementing the first aspect herein below, the heat flow control layer may comprise one or more plating layers of lower thermal conductivity (e.g., Ni, Pd, ENIG, ENEPIG or ceramic or oxide-based layer), and may serve to reduce the heat flux in the lateral direction while reinforcing thermal insulation for nearby sensitive areas. This configuration may enable a controlled, directional thermal management strategy within the semiconductor package or semiconductor module that can contribute to mitigating heat-induced damage to heat-sensitive devices and may also enhance the thermal and functional reliability of the semiconductor module.

A second aspect of this disclosure provides an uneven portion (110R) formed on the upper surface of the heat flow control body (110) of a heat flow control device (100) to improve the bonding interface between the heat flow control body and an overlying heat dissipation device, such as a vapor chamber. The roughened upper surface increases the mechanical interlocking between the heat flow control body and the adhesive material used to attach it to the dissipation structure, thereby enhancing the adhesive strength of the interface. According to the embodiments implementing the second aspect, the roughed upper surface improves the reliability of the bond under thermal cycling conditions, where expansion and contraction can otherwise weaken the interface and lead to delamination. The improved bonding also allows for more effective transfer of heat into the heat dissipation structure by ensuring stable physical contact and reducing the risk of partial peeling or interface failure. In addition, the design consideration behind introducing surface roughness lies in maximizing the interface surface area without increasing the package footprint, thereby achieving enhanced adhesion without compromising layout efficiency.

A third aspect of this disclosure provides a configuration in which a plurality of spaced first connecting members (112), such as solder balls, are disposed under the heat flow control body (110) of a heat flow control device (100) to attach the heat flow control body (110) to a semiconductor package (211), which may contain a heat source. This implementation may contribute to mitigating the problem of thermal expansion stress accumulation. Unlike conventional designs using continuous metal TIM layers that cover the entire bonding area and suffer from stress concentration, the use of discrete and spaced solder joints between the heat flow control body (110) and the semiconductor package (211) allows mechanical stress to be distributed more evenly across the interface. The spacing between the solder balls creates mechanical compliance, enabling small, independent movements that accommodate differences in thermal expansion between the heat flow control body and the underlying structure. This structural approach reduces the likelihood of cracking or delamination under repeated heating and cooling cycles and maintains thermal conductivity through reliable contact points. The use of such distributed connections reflects a design strategy that balances thermal performance with mechanical resilience, especially in high-power or high-temperature applications where conventional full-surface adhesives would degrade more quickly.

### (First Embodiment)

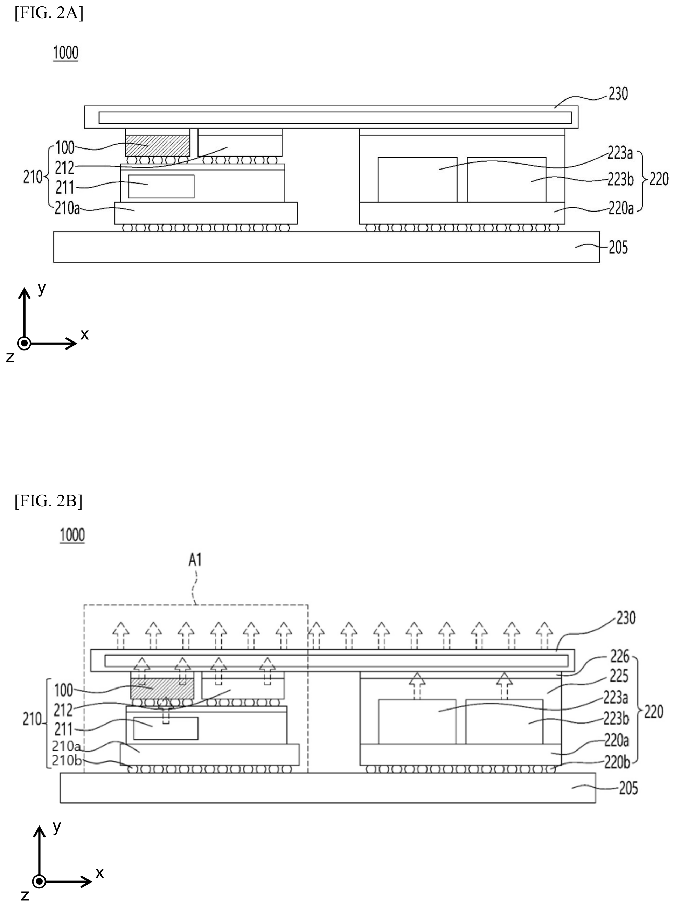

FIG. 2A is a cross-sectional view of a semiconductor package module (1000) according to a first exemplary embodiment of this disclosure, and FIG. 2B is a detailed drawing of the semiconductor package module (1000) according to the first embodiment illustrated in FIG. 2A.

Referring to FIG. 2A, the semiconductor package module (1000) according to the first embodiment may include a single semiconductor package (210) or multiple semiconductor packages (210, 220) disposed on a main board (205), and a heat dissipation device (230).

For example, a semiconductor package module (1000) according to an embodiment may include a first semiconductor package (210), a second semiconductor package (220) disposed on a main board (205), and a heat dissipation device (230) disposed on the first and second semiconductor packages (210, 220).

Each of the semiconductor packages (210, 220) may be a CSP (Chip Scale Package), an FC-CSP (Flip Chip-Chip Scale Package), an FC-BGA (Flip Chip Ball Grid Array), POP (Package On Package) or SIP (System In Package). However, this disclosure is not limited to these examples.

The main board (205) may be physically and/or electrically connected to various components of the semiconductor package module (1000), and various semiconductor devices may be mounted within the one or more semiconductor packages (210, 220).

The first semiconductor package (210) may include a single or multiple semiconductor devices (211, 212) and a heat flow control device (100). The one or more semiconductor devices (211, 212) may be disposed on a first package substrate (210a).

For example, the first semiconductor package (210) may include a first semiconductor device (211) disposed on a first package substrate (210a), a second semiconductor device (212) disposed spaced apart from the first semiconductor device (211), and a heat flow control device (100). The heat flow control device (100) may be disposed over the first semiconductor device (211) and may expose an upper surface that is configured to be attached to a heat dissipation structure, such as a heat sink or vapor chamber, for upward heat transfer. In some example implementations of the first embodiment, this upper surface may include an uneven portion (110R), as described herein below, to enhance bonding reliability with the heat dissipation structure and improve thermal interface performance.

The first package substrate (210a) may include at least one of a plurality of insulating layers, wiring layers, and via electrodes, and may further include an interposer substrate (not shown) to mount the first semiconductor device (211) and the second semiconductor device (212) on the interposer substrate. However, this disclosure is not limited to this example.

In the first embodiment, the heat flow control device (100) may be mounted on the first semiconductor device (211) so as to be disposed, at least in part, vertically above the first semiconductor device (211). For example, the heat flow control device (100) may be disposed to vertically overlap the first semiconductor device (211). However, this disclosure is not limited to this example. The heat flow control device (100) will be described in detail later.

The first semiconductor device (211) and the second semiconductor device (212) may include one or more active devices and/or one or more passive devices. In this disclosure, active devices may be electronic components that can control current flow and require an external power source to operate (e.g. amplify, switch, or generate electrical signals). As such active devices may be the main heat sources within a semiconductor package. In contrast, a passive device may, for example, refer to components like resistors, capacitors, or inductors that are part of the first semiconductor device (211) or the second semiconductor device (212) but do not perform active signal processing or amplification. For example, an active device may be a semiconductor chip in the form of an integrated circuit (IC) in which hundreds to millions of devices (e.g. transistors) are integrated into one chip. Logic chips or memory chips are exemplary examples of active devices.

In some example implementations of the first embodiments, the first semiconductor device (211) and the second semiconductor device (212) may be logic chips or memory chips, etc.

The logic chip may be an application processor (AP) chip, an analog-to-digital converter, an application-specific IC (ASIC), etc., In other examples implementations of the first embodiment, the logic chip may be a SoC (System on Chip) including a specific combination of these components. The AP chip may, for example, include at least one of a central processor (CPU), a graphic processor (GPU), a digital signal processor, an encryption processor, a microprocessor, and a microcontroller.

The memory chip may be a stack memory such as HBM. In addition, the memory chip may include a memory chip such as a volatile memory (e.g., DRAM), a non-volatile memory (e.g., ROM), or a flash memory.

Hereinafter, the first semiconductor device (211) may be a logic chip and the second semiconductor device (212) may be a memory chip. However, the invention is not limited to this example.

Furthermore, the second semiconductor package (220) may include a single or multiple semiconductor devices (223a, 223b). The one or more semiconductor devices (223a, 223b) may be disposed on the second package substrate (220a).

For example, the second semiconductor package (220) may include a third semiconductor device (223a) and a fourth semiconductor device (223b) spaced apart from each other and disposed on the second package substrate (220a).

The third semiconductor device (223a) and the fourth semiconductor device (223b) may include one or more active devices and/or one or more passive devices. In addition, the third semiconductor device (223a) and the fourth semiconductor device (223b) may be a logic chip or a memory chip, etc.

Recently, semiconductor packages are becoming larger in size as their functions increase, and AP or SoC (a chip that may include other functional chips in addition to AP) also generates more heat as their performance improves. Memory devices, such as HBM, used in servers are vulnerable to heat. This may be more problematic when such heat-sensitive devices are located closer to the application processor (AP) in a PC or smartphone with a small form factor, for example, in a structure in which multiple DRAMs are vertically stacked, or in which heat sources and heat-sensitive devices are combined into a single package. Therefore, in order for high-performance semiconductor devices (such as HBM) to be applied to personal electronic devices such as PCs or smartphones, it is important to stably manage the heat generation problem.

The semiconductor package module (1000) according to the first embodiment may include a heat dissipation device (230) disposed on the first semiconductor package (210) and the second semiconductor package (220). The heat dissipation device (230) may be a heat spreader or a vapor chamber. However, this disclosure is not limited to this example. The

If the heat dissipation device (230) is a vapor chamber, it may include an upper metal plate, a hollow structure, and a lower metal plate. The hollow structure may include a plurality of trench structures or a plurality of holes, and the plurality of trench structures or the plurality of holes may be filled with a working fluid. For example, the working fluid may be, but is not limited to, acetone, methanol, ethanol, or deionized water (DI-water).

According to an exemplary implementation of the first embodiment, when heat generated from the first semiconductor package (210) and the second semiconductor package (220) may be transferred to the lower metal plate of the heat dissipation device (230), the working fluid may vaporize, absorb latent heat of vaporization, move toward the upper metal plate, and condense into a liquid while releasing latent heat of vaporization. The condensed working fluid may be absorbed into the trench structure of the hollow structure and move toward the lower metal plate.

Referring to FIG. 2B, the first package substrate (210a) in the first semiconductor package (210) may be mounted on the main board (205) by the first adhesive member (210b). The first adhesive member (210b) may be solder balls.. However, this disclosure is not limited to this example.

In addition, in the second semiconductor package (220), the second package substrate (220a) may be mounted by the third adhesive member (220b). The third adhesive member (220b) may be solder balls. However, this disclosure is not limited to this example.

The third semiconductor device (223a) and the fourth semiconductor device (223b) may be disposed in the second package body (225). The second package body (225) may be joined to the heat dissipation device (230) by the fourth adhesive layer (226). The second package body (225) may include at least one of a plurality of insulating layers, wiring layers, and via electrodes. However, this disclosure is not limited to this example.

The fourth adhesive layer (226) may be a metal adhesive layer including a metal material, but the embodiments are not limited to this example. For example, the fourth adhesive layer (226) may include a Sn alloy adhesive layer, an In alloy adhesive layer, an Al alloy adhesive layer, etc. However, this disclosure is not limited to this example.

The characteristics of the first semiconductor package (210) will be described in detail later with reference to FIGS. 3A and 3B.

In semiconductor package modules like those shown in Figs. 2A and 2B, heat generated from semiconductor devices (e.g., logic chips) should be efficiently transferred upward to heat dissipation components, such as vapor chambers. However, achieving strong thermal conductivity typically requires rigid bonding layers, which can lead to delamination due to differences in the coefficient of thermal expansion (CTE) between adjacent materials. This creates a technical contradiction: optimizing for heat dissipation increases mechanical stress and risks interface failure. The semiconductor package according to the first embodiment, can solve the problem of this technical contradiction in that heat generated from an electronic device such as a semiconductor device is transferred upward while delamination due to a difference in the coefficient of thermal expansion of adjacent materials may be prevented.

Furthermore, controlling the flow of heat as described in the first embodiment of this disclosure may overcome the problem of memory devices such as HBM being damaged and the problem of reduced reliability of bonding layers caused by heat generated from a logic chip or the like that is moving to a heat sink or vapor chamber.

The technical characteristics of the first embodiment of this disclosure will be described in more detail below with reference to FIGS. 3A and 3B.

FIG. 3A is a cross-sectional view of the first semiconductor package (210A) according to the first embodiment. FIG. 3A shows an enlarged view of the first region (A1) of the semiconductor package module (1000) illustrated in FIG. 2B. FIG. 3B is a detailed drawing of the first semiconductor package (210A) according to the first embodiment illustrated in FIG. 3A.

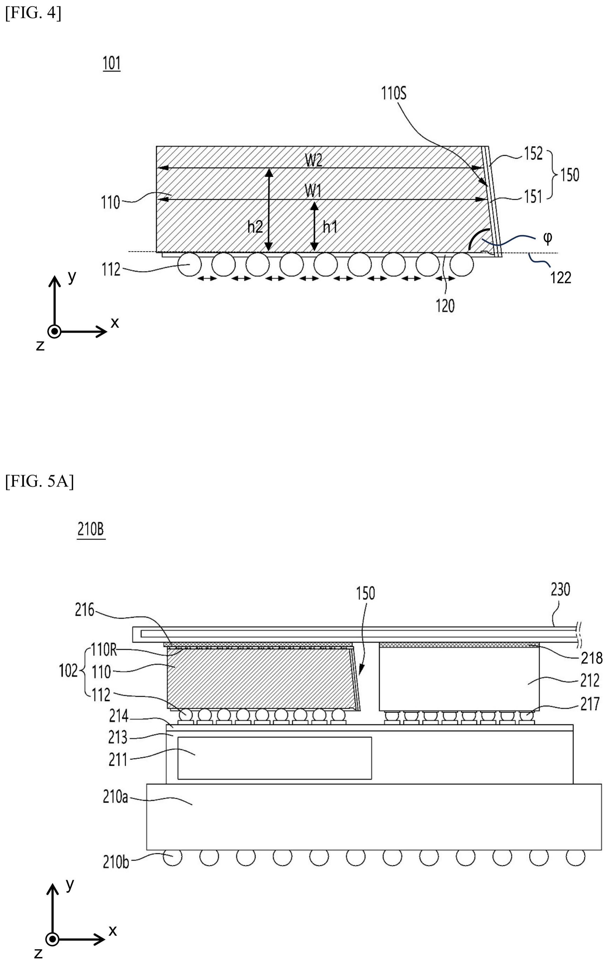

In addition, FIG. 4 is a detailed drawing of the first heat flow control device (101) according to the first embodiment.

First, referring to FIG. 3A, the first semiconductor package (210A) according to the first embodiment may include a single or multiple semiconductor devices (211, 212) and a first heat flow control device (101) disposed on a first package substrate (210a).

For example, the first semiconductor package (210A) of the first embodiment may include a first semiconductor device (211) disposed on a first package substrate (210a). Optionally, the first semiconductor package (21 0A) may include a second semiconductor device (212) disposed spaced apart from the first semiconductor device (211). The first semiconductor package (210A) further comprises a first heat flow control device (101). The first semiconductor device (211) may be disposed in a first package body (213). The first package body (213) may include at least one of a plurality of insulating layers, wiring layers, and via electrodes, but the first embodiment is not limited to these examples. In FIGS. 2A, 2B, 3A and 3B the second semiconductor device (212) may be disposed on the first package body (213). However, the second semiconductor device (212) may also be disposed adjacent to the first semiconductor (211) on the first package substrate (210a) or on an interposer structure (not shown).

The first heat flow control device (101) may be disposed to overlap the first semiconductor device (211), but the first embodiment is not limited to this example. The first heat flow control device (101) may be disposed, at least in part, vertically above the first semiconductor device (211) so that there is at least an overlap of the cross sections of the heat flow control device (101) and the first semiconductor device (211) in the vertical direction.

In FIGS. 2A, 2B, 3A and 3B the second semiconductor device (212) is positioned laterally adjacent (in x direction) to the first heat flow control device (101). Although the position of the first heat flow control device (101) is illustrated as being disposed on the left side of the second semiconductor device (212), the first embodiment is not limited to this relative positioning of the first heat flow control device (101) and the second semiconductor device (212). The position of the first heat flow control device (101) may be changed depending on the position of the first semiconductor device (211) and/or the position of the heat source in the first semiconductor device (211).

In addition, the size of the first semiconductor device (211) is not limited to the size illustrated in FIGS. 2A and 2B. The first semiconductor device (211) may have a size large enough to occupy the entire first package body (213) or only portion thereof as show in FIGS. 2A and 2B. Although FIGS. 2A and 2B show that the first semiconductor device (211) positioned in the first package body (213) so as to be vertically below the heat flow control device (101) (e.g. there is at least a partial or a full overlap between the cross sections of the heat flow control device (101) and the first semiconductor device (211) in the vertical direction), there is no specific limitation as to the position of the first semiconductor device (211) in the first package body (213) and/or with respect to the heat flow control body (110).

The heat flow control device (101) and the second semiconductor device (212) may be disposed on a metal wiring layer (214) provided on the first package body (213). A first connecting member (112) and a second connecting member (217), respectively, may be interposed between the heat flow control device (101) and the metal wiring layer (214), and between the and the second semiconductor device (212) and the metal wiring layer (214), respectively. The wiring layer (214) of the first package body (213) may be for example a redistribution layer (RDL layer), but this disclosure is not limited to this example. The first connecting member (112) of the heat flow control device (101) and the second connecting member (217) of the second semiconductor device (212) may include solder balls. When the first connecting member (112) of the heat flow control device (101) are implemented by means of solder ball, there is a stress dispersing effect generated according to the CTE difference at the bonding interface. Also, the expansion and contraction amount may be small for the thermal stress generated according to the CTE difference because voids or cracks do not occur compared to the Metal TIM material.

For example, if the first connecting member (112) of the heat flow control device (101) are implemented using solder balls, there is a stress dissipation effect due to the mutual separation, and accordingly, by dissipating the thermal expansion stress caused by the heat generated from the first semiconductor device (211). Therefore, the occurrence of peeling due to cracks or voids may be prevented, thereby improving the heat dissipation efficiency and bonding reliability at the bonding portion.

In addition, the second semiconductor device (212) and the heat flow control device (101) may be bonded to the heat dissipation device (230) by interposing a first adhesive layer (216) and second adhesive layer (218). The first adhesive layer (216) and/or the second adhesive layer (218) may be a metal adhesive layer including a metal material. For example, the first adhesive layer (216) and/or the second adhesive layer (218) may include a Sn alloy adhesive layer, an In alloy adhesive layer, an Al alloy adhesive layer, etc., but is not limited thereto. Optionally, first adhesive layer (216) and the second adhesive layer (218) may be formed as a single layer.

The first heat flow control device (101) may include a heat flow control body (110) and a first connecting member (112). In some example embodiments of the first embodiment, the first heat flow control device (101) may optionally further include a heat flow control layer (150) disposed on a side of the heat flow control body (110). In this context, the term "side" may for example refers to at least one lateral surface of the heat flow control body (110), positioned in the horizontal direction (x-direction) of the package layout as illustrated in the cross-sectional views (e.g., FIGS. 3A, 3B, 4, 5A, 5B and 6). This is to be distinguished from the upper surface, which extends in the vertical (y-direction) and typically faces the heat dissipation device (230), and the lower surface, which faces the first package body (213) or first the semiconductor device (211) and may be coupled thereto via the first connecting member (112).In one implementation of the second embodiment, the heat flow control body (110) of the first heat flow control device (101) may be formed by processing a sheet or foil of rolled copper material, which is selected for its high thermal conductivity, mechanical rigidity, and uniform grain structure. The rolled copper material may have a thickness in the range of approximately 100 µm to 700 µm, preferably in the range 200 µm to 600 µm, more preferably in the range 300 µm to 500 µm depending on the target dimensions and thermal performance requirements of the heat flow control device.

Still in accordance with the first embodiment, the heat flow control body (110) of the first heat flow control device (101) may be obtained by cutting or stamping the rolled copper sheet into a rectangular or square shape using precision shearing, laser cutting, or CNC milling techniques. These manufacturing methods allow for accurate dimensional control and flatness, which are essential for good thermal interface contact and subsequent integration into the semiconductor package structure. In some implementations of the second embodiment and optionally, the upper surface of the heat flow control body (110) may be subjected to post-processing treatments to achieve a desired average surface roughness in the desired range. The average surface roughness (Ra) of the uneven portion (110R) on the upper surface of the heat flow control body (110) may be formed by a technique such as pumice treatment, soft etching, or another roughness treatment such as CZ treatment, but the invention is not limited thereto. These techniques may also be combined with each other or further post-processing treatments to obtain a desired average surface roughness of the upper surface of the heat flow control body (110) that forms the uneven portion (110R).

In some example implementations of the first embodiment, heat flow control body may for example have width (x direction) and/or depths (z-direction) in a range of 2.5 mm to 25.0 mm, preferably 5.0 mm to 20.00 mm and a height (y direction) in a range of 0.1 mm to 1.5 mm, preferably 0.2 mm to 1.0 mm. These dimensions of the heat flow control body (110) may be for example selected to align with the physical and functional constraints of advanced semiconductor packages, such as system-on-chip (SoC) architectures, multi-die modules, or high-density memory-in-package configurations. A width and/or depth (x and z directions) in the range of approximately 2.5 mm to 25.0 mm allows the heat flow control body to at least partially overlap the footprint of one or more heat-generating devices (e.g., a logic die or SoC), thereby maximizing thermal coupling efficiency. Also, a more narrow range of 5.0 mm to 20.0 mm may be still compatible with today's common die sizes in 2.5D, 3D IC, and heterogeneous integration platforms. The height (y direction) of the heat flow control body may be in the range of 0.1 mm to 1.5 mm, preferably 0.2 mm to 1.0 mm, to ensure sufficient thermal conduction in the vertical direction while maintaining compatibility with the overall stack height and reliability constraints of modern package architectures. These thicknesses also provide enough structural rigidity to support secondary operations such as surface roughening or plating, without risk of deformation or warpage.

It should be understood that the dimensional ranges disclosed for the heat flow control body (110) are not intended to be limiting. Rather, these dimensions are illustrative of current design considerations and may be adjusted in response to future advances in semiconductor manufacturing technologies, which may enable or necessitate further miniaturization of package components. Accordingly, the dimensions of the heat flow control body (110) may be scaled or modified to suit evolving integration densities, thermal requirements, and layout constraints.

In some example implementations of the first embodiment, the heat flow control body (110) may include an inclined surface (110S) formed on at least one lateral side, onto which a heat flow control layer (150) may be applied. The inclined surface (110S) may serve both thermal and mechanical functions, such as directing heat away from heat-sensitive components and enhancing contact with encapsulant or molding material.

Various fabrication techniques may be employed to form such inclined surfaces, depending on material properties, dimensional constraints, and production requirements of the heat flow control body (110) and/or semiconductor module (1000). For example, precision CNC machining may be used to remove material at a defined angle, enabling accurate and repeatable shaping of inclined geometries. Laser ablation may be another applicable technique, wherein a focused laser beam selectively removes surface material to generate an inclined or sloped contour. In some cases, mechanical grinding or lapping may be used to bevel the edge of the heat flow control body, particularly in small-batch or prototyping scenarios. These are only some of multiple processing techniques that allow for the subsequent application of a heat flow control layer (150) to the inclined surface, and the disclosure is not limited to those techniques.

Specifically, referring to FIG. 4, the first heat flow control device (101) of the embodiment may include a heat flow control body (110) and a first connecting member (112). In addition, the first heat flow control device (101) may include a heat flow control layer (150) disposed on a side of the heat flow control body (110).

The heat flow control layer (150) may include a single or multiple heat flow control layers on one side of the heat flow control body (110) adjacent to the second semiconductor device (212). Accordingly, the heat flow control layer (150), when disposed on a side of the heat flow control body (110) is arranged along one or more vertical flanks of the heat flow control body (110), oriented in the x-direction and extending between the upper and lower surfaces. In some example implementations, the vertical flanks of the heat flow control body (110) may be inclined to promote directing the heat flow upward towards the upper surface of the heat flow control body (110). In the example embodiments of the first embodiment, this side-facing heat flow control layer (150) may be positioned such that it is thermally adjacent to (one or more) heat-sensitive component(s), such as the second semiconductor device (212), which may be disposed laterally (i.e., in the x-direction) beside the first semiconductor device (211). This configuration enables the heat flow control layer (150) to function as a thermal barrier, reducing heat propagation in the lateral (second) direction, and thereby minimizing thermal stress on the adjacent heat-sensitive device.

For example, the heat flow control layer (150) may include at least a first heat flow control layer (151) on one side of the heat flow control body (110) adjacent to the second semiconductor device (212).

Optionally, the heat flow control layer (150) may further include a second heat flow control layer (152) disposed on the first heat flow control layer (151).

The thermal conductivity of the heat flow control layer (150) may be lower than the thermal conductivity of the heat flow control body (110).

The embodiment may include the first heat flow control layer (151) and the second heat flow control layer (152) sequentially disposed on one side of a heat flow control body (110), and the thermal conductivity of the second heat flow control layer (152) may be lower than the thermal conductivity of the first heat flow control layer (151).

For promoting directional heat flow, the heat flow control body (110) may be formed of a material having high thermal conductivity, such that heat generated by the underlying heat-generating device can be efficiently transferred upward toward the heat dissipation structure. In contrast, the heat flow control layer (150), when provided, may be formed of a material having lower thermal conductivity relative to the heat flow control body (110), so as to suppress lateral heat transfer. In some example implementations of the first embodiment, the thermal conductivity of the heat flow control body (110) is higher than 300 W/(m K), preferably higher than 350 W/(m K) and more preferably higher than 400 W/(m K).

The thermal conductivity of the heat flow control layer (150) may be at least 75 W/(m·K) lower than that of the heat flow control body (110), preferably at least 150 W/(m·K) lower than that of the heat flow control body (110), more preferably at least 250 W/(m·K) lower than that of the heat flow control body (110), and even more preferably at least 300 W/(m·K) lower than that of the heat flow control body (110).

For example, the heat flow control body (110) may include a Cu material, such as rolled copper, which has excellent thermal conductivity. Further materials suitable for use in the heat flow control body (110) may include gold (Au), Cu alloys or Cu-composites (e.g., Cu-W, Cu-Mo), Aluminum (Al), or graphite. The heat flow control layer (150) may include a Ni material, which exhibits significantly lower thermal conductivity compared to copper and is well suited to function as a lateral thermal barrier.

A thermal conductivity of the heat flow control body (110) of the Cu material may be about 401 W/(m K), and a thermal conductivity of the heat flow control layer (150) of the Ni material may be about 90.9 W/(m K).

In implementations where the heat flow control layer (150) includes multiple stacked layers, the materials may be selected such that heat flow control layers farther from the heat flow control body (110) - i.e., closer to its exterior - exhibit progressively lower thermal conductivity, thereby enhancing the lateral thermal insulation effect. For example, the first heat flow control layer (151) may include a Ni plating layer, and the second heat flow control layer (152) may include a palladium (Pd) plating layer. In another example, the second heat flow control layer (152) may include an Electroless Nickel Immersion Gold layer (ENIG) or an Electroless Nickel Electroless Palladium Immersion Gold layer (ENEPIG) or an insulating coating material, but is not limited thereto. A heat flow control layer made of Pa material may be about 71 W/(m K).

In addition, for example, the first heat flow control layer (151) may include an ENIG layer or an ENEPIG layer, and the second heat flow control layer (152) may include a Ni plating layer.

Accordingly, according to the embodiment, a heat flow control layer (150) with lower thermal conductivity than the heat flow control body (110) may be provided on one side of the heat flow control body (110) adjacent to the second semiconductor device (212). This facilitates increasing the flow of heat generated from the first semiconductor device (211) toward the upward direction (y direction), and the flow of heat toward the side direction (x direction) can be reduced thereby, reducing the risk of the second semiconductor device (212) being damaged by heat.

In an example implementation of the first embodiment, the heat flow control body (110) may be formed from rolled copper material. Rolled copper generally exhibits higher purity than electrolytic copper material, due to its lower inclusion of impurities and reduced grain boundary defects introduced during processing. As a result, its the thermal conductivity is higher than that of electrolytic copper. Hence, the heat dissipation efficiency can be improved. In addition, rolled copper has a high density and high rigidity, and thus has the advantage of excellent rigidity design characteristics.

In some implementations of the first embodiment, the width of the heat flow control body (110) in the lateral direction (x-direction) may decrease in cross section from the lower end, which faces the first package body (213) or the first semiconductor device (211), toward the upper end, which faces the heat dissipation device (230). This tapering geometry may be realized by forming one or more inclined surfaces (e.g., the inclined surface 110S) on the lateral sides of the heat flow control body (110).

In some implementations of the first embodiment, the inclined surface (110S) of the heat flow control body (110) may be formed at an acute angle φ relative to the lower surface of the heat flow control body (110), such that the angle φ is less than 90°. The inclination may be selected to promote a geometry that deflects lateral heat flow back toward the vertical center of the heat flow control body (110), thereby enhancing the efficiency of upward-directed heat conduction and reducing thermal propagation toward laterally adjacent, heat-sensitive components (e.g., memory devices).

The angle φ is defined as the interior angle formed between the lower surface of the heat flow control body (110) - which extends generally in the horizontal direction (x direction) and is represented by the reference line 122 in FIG. 4 - and the inclined surface (110S) when viewed in cross-section (e.g. x-y plane in FIG. 4). The interior angle φ is measured within the volume of the heat flow control body. In other words, the interior angle φ represents the angle inside the material boundary, between the base plane of the body and the sloped wall surface.

To ensure both thermal deflection and mechanical integrity, the interior angle φ may be set within a range of approximately 45° to 85°, and preferably between 60° and 80° degrees. Angles below 45° may overly reduce the lateral wall height, making plating or structural processing more difficult, while angles approaching 90° may lose the desired heat-deflection effect and behave more like vertical walls. The selected angle may be further tuned depending on the placement of heat-sensitive components, required encapsulation geometry, and the inclination needed for optimized bonding with molding compounds or thermal interface materials.

In an exemplary implementation of the first embodiment, at least one side of the heat flow control body (110) may include an inclined surface (110S). The inclined surface (110S) of the heat flow control body (110) may be inclined so that a lateral distance to the second semiconductor device (212) increases progressively in the direction (y direction) of the heat dissipation device (230). This geometric configuration contributes to reducing thermal impact on the second semiconductor device (212) by increasing its separation from the path of heat flow originating from the first semiconductor device (211). Accordingly, there is an effect of reducing damage to the second semiconductor device (212) when the heat generated from the first semiconductor device (211) flows to the heat dissipation device (230). In some implementations of the first embodiment, the heat flow control body (110) may have one or more lateral sides facing one or more heat-sensitive semiconductor devices (212) that are formed by respective inclined surfaces (110S) and provided with respective heat flow control layers (150).

For example, in the first heat flow control device (101), a lower side of the heat flow control body (110) may have a first width (W1), and an upper side of the heat flow control body (110) may have a second width (W2) smaller than the first width (W1). Put different, in cross section, the heat flow control body (110) has a first width (W1) at a first vertical position and a second width (W2) smaller than the first width (W1) at a second vertical position that is above the first vertical position. The vertical position may be for example measured as the height (h1, h2) in the vertical direction (y direction) relative to some reference line, e.g. relative to the lower surface of the heat flow control body (110) in cross section represented by the reference line 122 in FIG. 4.

For example, according to an example implementation of the embodiment, by controlling the first width (W1) of the lower side of the heat flow control body (110) to be larger than the second width (W2) of the upper side, the contact area with the first semiconductor device (211) is expanded, so that the heat generated from the first semiconductor device (211) efficiently moves toward the upper direction of the heat dissipation device (230), while reducing heat damage to the second semiconductor device (212).

In some example implementations of the first embodiment, the first heat flow control device (101) may have a lower protective layer (120) disposed under the heat flow control body (110) (i.e. a surface facing towards first package body (213) or the first semiconductor device (211)) and may include a plurality of spaced first connecting members (112). The lower protective layer (120) may be a solder resist. The first connecting members (112) may include solder balls. The first connecting members (112) may be provided on the protective layer (120). In the case where the first connecting members (112) are solder balls, there is a stress distribution effect that occurs according to the CTE difference at the bonding interface, and there is an effect that voids or cracks do not occur compared to metal TIM materials.

In some example implementation of the first embodiment, the heat flow control layer (150) may be applied directly to the inclined surface (110S) and may serve to suppress or absorb lateral heat conduction away from a heat-generating device, such as a logic die or processor, and to minimize thermal exposure to laterally adjacent heat-sensitive components, such as memory chips. As noted above, in some example implementations of the first embodiment, the heat flow control layer (150) may be composed of two or more metal plating layers stacked in such a way that the thermal conductivity of each successive outer layer is lower than that of the underlying layer, thereby establishing a thermal gradient that attenuates lateral heat transfer.

In one exemplary configuration, a nickel (Ni) plating layer may be deposited directly onto the inclined surface (110S), serving as both a thermal barrier and a mechanical adhesion layer. Optionally, a palladium (Pd) plating layer may be applied over the Ni layer. Optionally, the outermost layer may be formed from an insulating or semi-metallic material with even lower thermal conductivity, such as a thin ceramic or oxide-based coating (e.g. having a thermal conductivity of approx. 1 W/m·K to 10 W/m·K), depending on process compatibility. This multilayer structure may also be implemented using techniques such as Electroless Nickel Electroless Palladium Immersion Coating, where the outermost layer is intentionally selected to exhibit the lowest thermal conductivity within the stack.

Deposition of these layers may be carried out using electroless plating or conformal physical deposition, both of which allow for uniform coating of non-planar surfaces, including sloped or inclined sidewalls. Example layer thicknesses may include a Ni layer of approximately 3 µm to 10 µm and a Pd layer of 0.05 µm to 0.5 µm. An optional thin outer insulating layer or passivation layer that may be provided may have a thickness of up to 1 µm, although these values may be tailored according to the thermal control requirements of the package.

The inclined geometry of the surface (110S), in combination with the layered structure of progressively lower thermal conductivity materials, enables a directional thermal control scheme. Heat is preferentially conducted vertically through the main body of the heat flow control structure toward a dissipation element (e.g., a vapor chamber), while lateral heat propagation is significantly reduced, thereby improving thermal isolation and reliability of heat-sensitive regions within the semiconductor module.

Referring again to FIG. 3B, according to the shown implementation of the first embodiment, the problem of damage of the second semiconductor device (212), such as HBM, and thus reduced reliability in the process of heat generated from the first semiconductor device (211), such as a logic chip, being transferred to a heat sink or vapor chamber, may be solved by controlling the flow of heat.

For example, according to an embodiment, the heat flow control layer (150) can maximize the first direction heat flow (F1) toward the upper side (y direction) by the first heat flow control device (101) disposed to overlap the first semiconductor device (211), but the heat flow control layer (150) can minimize the second direction heat flow (F2) toward the second semiconductor device (212) such as the HBM (in x direction). There is thus a technical effect that may minimize thermal damage to the second semiconductor device (212), such as the memory device, thereby improving reliability.

For example, according to an embodiment, a heat flow control layer (150) having lower thermal conductivity may be provided on one side of the heat flow control body (110) adjacent to the second semiconductor device (212), thereby maximizing the first direction heat flow (F1) of the heat generated from the first semiconductor device (211) toward the upper side, and reducing the second direction heat flow (F2) toward the side, thereby providing a technical effect of reducing damage to the second semiconductor device (212).

In addition, since the heat flow control layer (150) has a plurality of heat flow control layers having lower thermal conductivity than the material of the heat flow control body (110). For example, the heat flow control layer (150) may be a composite layer of a first heat flow control layer (151) and a second heat flow control layer (152) such that the second direction heat flow (F2) of the side may be further reduced. Accordingly, the first direction heat flow (F1) of the upper side may be maximized while minimizing damage to the second semiconductor device (212).

In addition, according to the embodiment, one side of the heat flow control body (110) in the first heat flow control device (101) may include an inclined surface (110S), and the second width (W2) of the upper side of the heat flow control body (110) is smaller than the first width (W1) of the center. This configuration may be used to increase the distance from the second semiconductor device (212). There is thus an effect of minimizing the second direction heat flow (F2) toward the second semiconductor device (212) and minimizing thermal damage to the second semiconductor device (212), such as a memory device, thereby improving reliability.

In addition, the first heat flow control device (101) may include a plurality of spaced solder ball-shaped first connecting members (112) at the lower side of the heat flow control body (110). This example implementation may facilitate dispersing thermal expansion stress caused by heat generated from the first semiconductor device (211). Accordingly, delamination caused by cracks or voids that may occur in the connecting members of the Metal TIM material may be prevented, thereby improving the heat dissipation efficiency and bonding reliability in the bonding portion.

### (Second Embodiment)

FIG. 5A is a cross-sectional view of a second semiconductor package (210B) according to the second embodiment. FIG. 5B is a detailed drawing of a second semiconductor package (210B) according to the second embodiment illustrated in FIG. 5A. FIG. 6 is a detailed drawing of a second heat flow control device (102) according to the second embodiment.

Optionally, the second semiconductor package (210B) according to the second embodiment may adopt the technical features of the first semiconductor package (210A) according to the first embodiment described above, and the main features of the second embodiment will be described below.

Referring to FIG. 5A, the second semiconductor package (210B) according to the second embodiment may include a single or multiple semiconductor devices and a second heat flow control device (102) disposed on the first package substrate (210a).

For example, as explained in connection with the first embodiment, the second semiconductor package (210B) of the second embodiment may include a first semiconductor device (211) disposed on the first package substrate (210a), a second semiconductor device (212) disposed spaced apart from the first semiconductor device (211), and a second heat flow control device (102).

The second heat flow control device (102) may be disposed to vertically overlap the first semiconductor device (211).

The heat flow control device (102) and the second semiconductor device (212) may be disposed on a metal wiring layer (214) with a first connecting member (112) and a second connecting member (217), respectively, interposed. The first connecting member (112) and the second connecting member (217) may include solder balls.

Like in the first embodiment, the second semiconductor device (212) and the second heat flow control device (102) may be bonded to the heat dissipation device (230) with first adhesive layer (216) and a second adhesive layer (218) interposed therebetween. The first adhesive layer (216) and/or the second adhesive layer (218) may be a metal adhesive layer including a metal material.

The second heat flow control device (102) of the embodiment may include a heat flow control body (110), a first connecting member (112), and a heat flow control layer (150) disposed on the side of the heat flow control body (110).

In accordance with the second aspect, the second heat flow control device (102) according to an exemplary embodiment of this disclosure may include a heat flow control body (110) and an uneven portion (110R) on the upper surface of the heat flow control body (110). As shown in FIG. 6, the second heat flow control device (102) of the embodiment may include the uneven portion (110R) on the upper surface of the heat flow control body (110).

For example, a roughness (R2) of the uneven portion (110R) on the upper surface of the heat flow control body (110) may be realized, for example, using techniques such as pumice treatment, soft etching, or roughness treatment such as Czochralski processing (CZ processing), but is not limited thereto. For example, the uneven portion (110R) on the upper surface of the heat flow control body (110) may have an average roughness (Ra) in the range of 0.1 *µ*m (inclusive) to 0.5 *µ*m (inclusive), but is not limited thereto. In other examples, the upper surface of the heat flow control body (110) may have an average roughness (Ra) in the range of 0.15 *µ*m (inclusive) to 0.5 *µ*m (inclusive), preferably in the range of 0.2 *µ*m (inclusive) to 0.5 *µ*m (inclusive). In yet other examples, the upper surface of the heat flow control body (110) may have an average roughness (Ra) in the range of 0.1 *µ*m (inclusive) to 0.4 *µ*m (inclusive), preferably in the range of 0.1 *µ*m (inclusive) to 0.3 *µ*m (inclusive). In yet further examples, the upper surface of the heat flow control body (110) may have an average roughness (Ra) in the range of 0.2 *µ*m (inclusive) to 0.4 *µ*m (inclusive), preferably in the range of 0.2 *µ*m (inclusive) to 0.3 *µ*m (inclusive). The upper surface of the heat flow control body (110) may have an average surface roughness (Ra) of 0.05 *µ*m, 0.05 *µ*m, 0.10 *µ*m, 0.15 *µ*m, 0.20 *µ*m, 0.25 *µ*m, 0.30 *µ*m, 0.35 *µ*m, 0.40 *µ*m 0.45 *µ*m, or 0.50 *µ*m.

Accordingly, since the upper surface of the heat flow control body (110) of the second heat flow control device (102) is provided with the uneven portion (110R), an adhesive strength between the second heat flow control device (102) and the heat dissipation device (230) - such as the vapor chamber - can be improved and the adhesive area can be increased. This may reduce the possibility of peeling and improves the bonding reliability between the second heat flow control device (102) and the heat dissipation device (230). Furthermore, the heat dissipation efficiency toward the upper first direction heat flow (F1) can be maximized.

In the second heat flow control device (102), a roughness (R2) of the uneven portion (110R) on the upper surface of the heat flow control body (110) may be greater than the roughness (R1) of the inclined surface (110S) on one lateral side of the heat flow control body (110), but is not limited thereto.

Since the uneven portion (110R) is provided on the upper surface of the heat flow control body (110) of the second heat flow control device (102), the bonding area between the second heat flow control device (102) and the heat dissipation device (230) is increased, thereby providing a technical effect of maximizing the upper first direction heat flow (F1).

Optionally, as shown in FIG. 6, the second heat flow control device (102) of the second embodiment may include a heat flow control layer (150) disposed on the side of the heat flow control body (110), in addition to the uneven portion (110R) on the upper surface of the heat flow control body (110).

In those implementations of the second embodiments, the heat flow control layer (150) may be configured as described in the first embodiment above. For example, the heat flow control layer (150) may include a first heat flow control layer (151) and a second heat flow control layer (152). The first heat flow control layer (151) may include a nickel-plating layer, and the second heat flow control layer (152) may include a gold plating layer. For example, the second heat flow control layer (152) may include an ENIG layer or an ENEPIG layer, but is not limited thereto. For example, the first heat flow control layer (151) may include an ENIG layer or an ENEPIG layer, and the second heat flow control layer (152) may include a nickel-plating layer.

Accordingly, according to some implementations of the second embodiment, a heat flow control layer (150) having lower thermal conductivity may be provided on one side of the heat flow control body (110) adjacent to the second semiconductor device (212), and the technical effect of increasing the flow of heat generated from the first semiconductor device (211) toward the upper direction, which is the location of the heat dissipation device (230), and reducing the flow toward the side direction may be achieved, thereby reducing damage to the second semiconductor device (212).

In some implementations of the second embodiment, the heat flow control body (110) may include a rolled copper material. When the heat flow control body (110) is provided with a rolled copper material, the purity of rolled copper material is higher than that of an electrolytic copper material. Thus, the thermal conductivity is higher, thereby improving the heat dissipation efficiency. In addition, the rolled copper has a high density and therefore has high rigidity, and thus has the advantage of excellent rigidity design characteristics.

In accordance with the second embodiment, the second heat flow control device (102) of the embodiment may include an uneven portion (110R) on the upper surface of the heat flow control body (110) compared to the first heat flow control device (101). Optionally further, the second heat flow control device (102) of the embodiment may include a slope (110S) on one side of the heat flow control body (110) compared to the first heat flow control device (101).

In the second heat flow control device (102) of some example implementations of the second embodiment, the roughness of the uneven portion (110R) on the upper surface of the heat flow control body (110) may be greater than the roughness of the slope or inclined surface (110S) provided on at least one side of the heat flow control body (110).

Accordingly, since the upper surface of the heat flow control body (110) of the second heat flow control device (102) is provided with an uneven portion (110R), the adhesive strength between the second heat flow control device (102) and the heat dissipation device (230) such as the vapor chamber can be improved and the adhesive area can be increased. Thereby the possibility of peeling may be reduced and the bonding reliability between the second heat flow control device (102) and the heat dissipation device (230) may be improved. Also, there is a technical effect of maximizing the heat dissipation efficiency toward the upper first direction heat flow (F1).

Furthermore, when at least one side surface of the heat flow control body (110) is provide with a heat flow control layer (150), there is a technical effect of reducing the damage to the second semiconductor device (212) by reducing the heat flow in the lateral direction by the inclined surface (110S) of the heat flow control body (110).

In addition, in some implementations of the second embodiment, the inclined surface (110S) of the heat flow control body (110) may serve to increase the contact area between the heat flow control body (110) and the EMC (Epoxy Molding Compound) molding material (not shown).Thereby the interface bonding strength may be improved, which will also improve module's reliability by reducing the likelihood of delamination or mechanical failure under thermal or mechanical stress.

Like in the first embodiment, the lower side of the heat flow control body (110) in the second heat flow control device (102) may have a first width (W1), and the upper side of the heat flow control body (110) may have a second width (W2) smaller than the first width (W1). For example, by controlling the first width (W1) of the lower side of the heat flow control body (110) to be larger than the second width (W2) of the upper side, the contact area with the first semiconductor device (211) is expanded, so that the heat generated from the first semiconductor device (211) efficiently moves toward the heat dissipation device (230), while reducing heat damage to the second semiconductor device (212). Also like in the first embodiment, the second heat flow control device (102) may have a lower protective layer (120) disposed under the heat flow control body (110) and may include a plurality of first connecting members (112) spaced from each other. The lower protective layer (120) may be a solder resist, and the first connecting member (112) may include solder balls. If the first connecting member (112) use solder balls, there is a stress distribution effect that occurs according to the CTE difference at the bonding interface, and there is an effect that voids or cracks do not occur compared to the metal TIM material.

Referring again to FIG. 5B, the second semiconductor package (210B) of the second embodiment can maximize the first direction heat flow (F1) toward the upper side by the second heat flow control device (102) that is disposed to vertically overlap the first semiconductor device (211), and can minimize the second direction heat flow (F2) toward the second semiconductor device (212), such as the HBM, by the heat flow control layer (150). Thereby thermal damage to the second semiconductor device (212), such as the memory device, is minimized and reliability can be improved.

For example, a heat flow control layer (150) having lower thermal conductivity may be provided on at least one side of the heat flow control body (110) adjacent to one or more second semiconductor devices (212), thereby maximizing the first direction heat flow (F1) of the heat generated from the first semiconductor device (211) toward the upper side and reducing the second direction heat flow (F2) toward the side. There is thus a technical effect of reducing damage to the second semiconductor device (212).

In some implementations of the second embodiment, the heat flow control layer (150) may have a plurality of heat flow control layers having lower thermal conductivity than the material of the heat flow control body (110). For example, the heat flow control layer (150) may be a composite layer of a first heat flow control layer (151) and a second heat flow control layer (152). This way, the second direction heat flow (F2) towards the side of the heat flow control body (110) may be further reduced, and accordingly, the first direction heat flow (F1) toward the upper side of the heat flow control body (110) may be maximized while damage to the second semiconductor device (212) can be minimized.

The second semiconductor package (210B) of the second embodiment may have a technical effect of further maximizing the first direction heat flow (F1) toward the upper side by providing the uneven portion (110R) on the upper surface of the heat flow control body (110) of the second heat flow control device (102), thereby increasing the bonding area between the second heat flow control device (102) and the heat dissipation device (230).

In some example implementations of the second embodiment, one side of the heat flow control body (110) in the second heat flow control device (102) may include the inclined surface (110S), and the second width (W2) of the upper side of the heat flow control body (110) is made smaller than the first width (W1) of the center, thereby increasing the distance from the second semiconductor device (212). Accordingly, there is a technical effect of minimizing the second direction heat flow (F2) toward the second semiconductor device (212), thereby minimizing thermal damage to the second semiconductor device (212), such as a memory device, thereby improving reliability.

In some example implementations of the second embodiment, the second heat flow control device (102) may include a plurality of solder ball-shaped first connecting members (112) spaced from each other at the bottom of the heat flow control body (110), thereby dispersing the thermal expansion stress caused by heat generated from the first semiconductor device (211). This way, there is an effect of preventing delamination caused by cracks or voids in the first connecting member (112) and improving the heat dissipation efficiency and bonding reliability at the bonding portion.

### (Third to Fifth Embodiments)

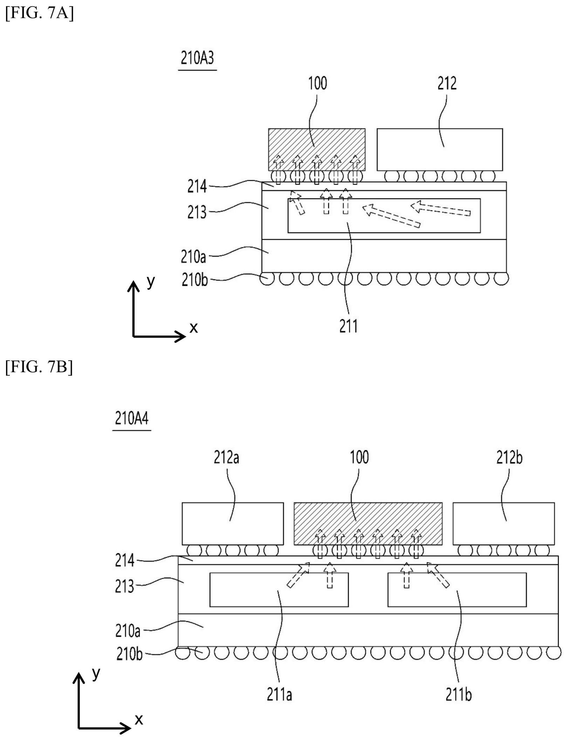

Next, FIGS. 7A to 7C are exemplary diagrams of semiconductor packages (210A3, 210A4, 210A5) according to the third to fifth embodiments.

The semiconductor packages (210A3, 210A4, 210A5) according to the third embodiment to the fifth embodiment may optionally adopt the technical features of the first semiconductor packages (210A, 210B) of the first embodiment to the second embodiment described above. The features of the semiconductor packages (210A3, 210A4, 210A5) according to the third embodiment to the fifth embodiment will be described below.

Referring to FIG. 7A, the semiconductor package (210A3) according to the third embodiment is shown. The semiconductor package (210A3) may include a plurality of first semiconductor devices. For example, the semiconductor package (210A3) according to the third embodiment may include a first semiconductor device (211) disposed on a first package substrate (210a). In addition, the semiconductor package (210A3) according to the third embodiment may include a second semiconductor device (212) disposed spaced apart from the first semiconductor device (211) and a heat flow control device (100).

The first semiconductor device (211) and the second semiconductor device (212) may include an active device and/or a passive device. For example, the active device may be a semiconductor chip in the form of an integrated circuit (IC) in which hundreds to millions of devices are integrated into one chip. In addition, the first semiconductor device (211) may be a logic chip such as an AP or SOC, and the second semiconductor device (212) may be a memory chip, but is not limited thereto.

In some example implementations of the third embodiment, the size of the first semiconductor device (211) may be larger than the size of the second semiconductor device (212).

In some example implementations of the third embodiment, the heat flow control device (100) quickly and efficiently dissipates heat generated from the first semiconductor device (211) having a large size, thereby controlling the flow of heat generated from the first semiconductor device (211) toward the heat flow control device (100), thereby controlling the generated heat not to flow toward the second semiconductor device (212), and the embodiment may place the heat flow control device (100) according to the main heat source that generates heat.

Next, referring to FIG. 7B, the semiconductor package (210A4) according to the fourth embodiment is shown. The semiconductor package (210A4) may include a plurality of second semiconductor devices. For example, the semiconductor package (210A4) according to the fourth embodiment may include a first semiconductor device (211a) and a second semiconductor device (211b) disposed on a first package substrate (210a). In addition, the semiconductor package (210A4) according to the fourth embodiment may include a third semiconductor device (212a), a fourth semiconductor device (212b) disposed spaced apart from the first semiconductor device (211a) and the second semiconductor device (211b), and a heat flow control device (100). The heat flow control device (100) may be disposed between the third semiconductor device (212a) and the fourth semiconductor device (212b).

In FIG. 7B, the heat flow control device (100) may have two opposing lateral sides respectively facing the first semiconductor device (211a) and the second semiconductor device (211b). In accordance with the heat management strategies described in connection with the first and second embodiments, each of these opposing sides may be provided with a corresponding heat flow control layer (150) having lower thermal conductivity than the heat flow control body (110), for the purpose of limiting lateral heat propagation toward adjacent heat-sensitive components.

Furthermore, the lateral sides of the heat flow control body (110) in this embodiment may each include an inclined surface (110S), such that the distance to the adjacent semiconductor devices (212a, 212b) increases toward the top of the package. The heat flow control layers (150) may be formed on these inclined surfaces to function as thermal barriers, thereby suppressing sideward heat flow while directing the majority of thermal energy vertically upward. This dual-sided implementation of the heat flow control layer (150) supports bidirectional thermal shielding in the lateral (x) direction and is particularly advantageous in package layouts where the heat flow control device (100) is centrally positioned between multiple heat-sensitive components.

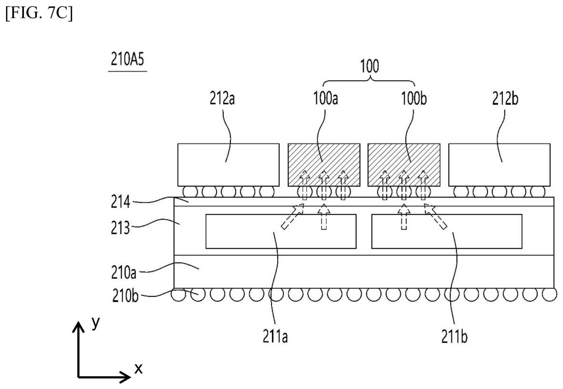

Next, referring to FIG. 7C, the semiconductor package (210A5) according to the fifth embodiment may include a plurality of heat flow control devices (100). For example, the semiconductor package (210A5) according to the fifth embodiment may include a first semiconductor device (211a) and a second semiconductor device (211b) disposed on a first package substrate (210a). In addition, the semiconductor package (210A5) according to the fifth embodiment may include a third semiconductor device (212a), a fourth semiconductor device (212b) and a heat flow control device (100) disposed spaced apart from each other on the first semiconductor device (211a) and the second semiconductor device (211b). The heat flow control device (100) may include, but is not limited to, a first heat flow control device (100a) and a second heat flow control device (100b) disposed between a third semiconductor device (212a) and a fourth semiconductor device (212b).

In FIG. 7C, each of the heat flow control devices (100a, 100b) may be provided with one or more heat flow control layers (150) formed on their respective lateral sides facing adjacent semiconductor devices. These layers, as described in the first and second embodiments, may consist of materials with lower thermal conductivity, such as nickel, palladium, or composite layers like ENIG or ENEPIG, to suppress lateral heat flow toward neighboring heat-sensitive devices. Moreover, the lateral sides of the heat flow control bodies (110a, 110b) may include inclined surfaces (110S), configured such that the distance from the inclined surface to the adjacent semiconductor device increases upward toward the heat dissipation structure. Heat flow control layers (150) applied to these inclined surfaces may enhance both thermal insulation and mechanical bonding with surrounding molding materials, contributing to improved thermal management and structural reliability of the overall package.

This distributed implementation of multiple heat flow control devices enables a modular and scalable thermal architecture, allowing the thermal shielding and directional heat transfer strategy to be effectively applied across more complex semiconductor packages that contain multiple high-power and heat-sensitive components.

In the embodiments of this disclosure described herein above, the connection members (e.g. connection members (112), (217)) are described as being implemented using solder balls. This implementation is only exemplary, and alternative implementations of those connecting members may be used. These alternative implementations may provide similar technical effects as solder balls, for example, they may facilitate mechanical decoupling for thermal expansion stress relief, reliable thermal contact, and maintained electrical insulation where applicable. For example, the connecting members may alternatively comprise or be implemented using metal pillars, composite interconnect structures, or elastomeric thermal bumps incorporating conductive or compliant materials. Furthermore, low-melting-point alloys, thermally conductive adhesives, or phase-change interface materials formed in discrete regions may also serve as functional equivalents of the connecting members, provided they maintain physical separation and spacing between bonding points to enable stress dispersion.

In the embodiments of this disclosure described herein above, the adhesive layers (e.g. first adhesive layer (216) and second adhesive (218)) are described as a metal adhesive layer, for example, comprising a Sn alloy, In alloy, or Al alloy. It is to be understood that the disclosure is not limited to these specific materials. Alternative bonding layer configurations may be employed, provided they ensure stable thermal and mechanical performance at high temperatures, such as those encountered in power semiconductor applications (which may operate at 350 °C or above). In particular, bonding layers formed using sintered metal materials, such as sintered silver (Ag) or copper (Cu) pastes, or transient liquid phase sintering (TLPS) systems, may be alternatives for such use cases. These materials can form robust, conductive interfaces through low-temperature processing followed by metallurgical transformation, and once formed, exhibit thermal stability well beyond 350 °C. TLPS and sintered metal joints also provide high thermal conductivity and mechanical integrity under thermal cycling. Depending on the expected temperatures during operation, also polymer-based thermally conductive adhesives (e.g., filled epoxies or silicones) may be used in lower-temperature applications, noting that they may typically exhibit thermal degradation or loss of mechanical properties above 200-250 °C, and therefore are suitable alternatives for the adhesive layers at lower operating temperatures. Similarly, phase-change materials (PCMs), thermal interface pads, or elastomeric bonding layers may also be alternatives for providing adhesive layers, again depending on the operation temperatures expected during operation of the semiconductor modules.

Although the above has been described with reference to embodiments of the present invention, it will be readily understood by those skilled in the art that the present invention may be variously modified and changed within the scope of the invention described in the following claims.

### (Example Embodiments)

The following Example Embodiments describe advantageous implementations of this disclosure.

Example Embodiment 1 provides a heat flow control device of a semiconductor package, comprising: a heat flow control body (110); and a heat flow control layer (150) disposed on a side of the heat flow control body (110); wherein the heat flow control layer (150) comprises a plating layer.

Example Embodiment 2 relates to the heat flow control device according to Example Embodiment 1, wherein the heat flow control layer (150) comprises a first heat flow control layer (151) and a second heat flow control layer (152) sequentially disposed on a side of the heat flow control body (110).

Example Embodiment 3 relates to the heat flow control device according to Example Embodiment 2, wherein the first heat flow control layer (151) comprises a nickel-plating layer, and the second heat flow control layer (152) comprises a gold plating layer.

Example Embodiment 4 relates to the heat flow control device according to Example Embodiment 3, wherein the second heat flow control layer (152) comprises an electroless nickel immersion gold layer (ENIG layer) or an electroless nickel electroless palladium immersion gold layer (ENEPIG layer).

Example Embodiment 5 relates to the heat flow control device according to any one of Example Embodiments 1 to 4, wherein one side of the heat flow control body (110) comprises an inclined surface.

Example Embodiment 6 relates to the heat flow control device according to any one of Example Embodiments 1 to 5, wherein a lower side of the heat flow control body (110) has a first width (W1), and an upper side of the heat flow control body (110) comprises a second width (W2) smaller than the first width (W1).

Example Embodiment 7 relates to the heat flow control device according to any one of Example Embodiments 1 to 6, further comprising a lower protective layer (120) disposed in a first region under the heat flow control body (110), and a plurality of spaced first connecting members (112) disposed in a second region under the heat flow control body (110).

Example Embodiment 8 relates to the heat flow control device according to Example Embodiment 7, wherein the lower protective layer (120) comprises a solder resist, and wherein the first connecting member (112) comprises a solder ball.

Example Embodiment 9 relates to the heat flow control device according to any one of Example Embodiments 1 to 8, wherein the heat flow control body (110) comprises an uneven portion (110R) on an upper surface thereof.

Example Embodiment 10 relates to the heat flow control device according to Example Embodiment 9, wherein a roughness of the upper surface of the heat flow control body (110) is greater than that of a side surface of the heat flow control body (110S).

Example Embodiment 11 provides a semiconductor package, comprising: a first semiconductor device (211) disposed on a first package substrate (210a); a heat flow control device (101, 102) disposed on the first semiconductor device (210a); and a second semiconductor device (212) disposed spaced apart from a side of the first heat flow control device (101, 102); wherein the heat flow control device (101, 102) comprises the heat flow control device of any one of Example Embodiments 1 to 10.

Example Embodiment 12 relates to the semiconductor package according to Example Embodiment 11, wherein the heat flow control device (101, 102) is disposed so as to overlap the first semiconductor device (211) vertically.

Example Embodiment 13 relates to the semiconductor package according to Example Embodiment 11 or Example Embodiment 12, further comprising a heat dissipation device (230) disposed on the second semiconductor device (212) and the heat flow control device (101, 102).

Example Embodiment 14 relates to the semiconductor package according to Example Embodiment 13, wherein the heat flow control layer (150) is disposed on one side of the heat flow control body (110) adjacent to the second semiconductor device (212).

Example Embodiment 15 provides a semiconductor module including the semiconductor package according to any one of Example Embodiments 1 to 14.

### (Reference Numbers)

10R1, 10R2, 10R3, 10R4: semiconductor packages
20a: first electronic device
20b: second electronic device
20c: electronic devices
30a: first adhesive layer
30b: second adhesive layer
30M1: first metal adhesive layer
30M2: second metal adhesive layer
40: heat dissipation plate
50: heat sink
100: heat flow control device
101: first heat flow control device
102: second heat flow control device
110: heat flow control body
110a: first heat flow control body
110b: second heat flow control body
110R: uneven portion (roughened surface)
110S: inclined surface of the heat flow control body
112: first connecting member (e.g., solder balls)
117: second connecting member (e.g., solder balls)
120: lower protective layer
122: lower surface of the heat flow control body
150: heat flow control layer
151: first heat flow control layer
152: second heat flow control layer
205: main board
210: first semiconductor package
210a: first package substrate
210b: second package substrate
210A1-210A5: semiconductor packages
211: first semiconductor device
211a: first semiconductor device
211b: second semiconductor device
212: second semiconductor device
212a: third semiconductor device
212b: fourth semiconductor device
213: first package body
214: metal wiring layer
215: metal wiring layer
216: first adhesive layer
218: second adhesive layer
217: second connecting member
220: second semiconductor package
220a: second package substrate
220b: third adhesive member
223a: third semiconductor device
223b: fourth semiconductor device
225: second package body
226: fourth adhesive layer 230: heat dissipation device (e.g., vapor chamber)
1000: semiconductor package module

## Claims

1. A heat flow control device (101, 102) for use in a semiconductor package (210A), the heat flow control device (101, 102) comprising:
a heat flow control body (110) having a lower surface that is to face a heat generating semiconductor device; and
a heat flow control layer (150) disposed on a lateral side of the heat flow control body (110) that is to face a heat-sensitive semiconductor device, wherein heat flow control layer (150) has a lower thermal conductivity than the heat flow control body (110).

2. The heat flow control device according to claim 1, wherein thermal conductivity of the heat flow control layer (150) may be at least 75 W/(m·K) lower than that of the heat flow control body (110), preferably at least 150 W/(m·K) lower than that of the heat flow control body (110), more preferably at least 250 W/(m·K) lower than that of the heat flow control body (110).

3. The heat flow control device according to claim 1 or 2, wherein the heat flow control layer (150) comprises a first heat flow control layer (151) and a second heat flow control layer (152) sequentially disposed on the lateral side of the heat flow control body (110).

4. The heat flow control device according to claim 3, wherein the first heat flow control layer (151) comprises a nickel-based plating layer, and the second heat flow control layer (152) comprises a palladium-based plating layer.

5. The heat flow control device according to claim 4, wherein the second heat flow control layer (152) comprises an electroless nickel immersion gold layer (ENIG layer) or an electroless nickel electroless palladium immersion gold layer (ENEPIG layer).

6. The heat flow control device according to one of claims 1 to 5, wherein a ceramic or oxide-based coating layer is disposed on the heat flow control layer (150).

7. The heat flow control device according to any one of claims 1 to 6, wherein the lateral side of the heat flow control body (110) has an inclined surface (110S).

8. The heat flow control device according to claim 7, wherein an angle φ is defined as the interior angle formed between the lower surface of the heat flow control body (110) and the inclined surface (110S), and interior angle φ may be set within a range of approximately 45° (inclusive) to 85° (inclusive), and preferably between 60° (inclusive) and 80° (inclusive).

9. The heat flow control device according to any one of claims 1 to 8, wherein, in cross section, the heat flow control body (110) has a first width (W1) at a first vertical position, and a second width (W2) smaller than the first width (W1) at a second vertical position that is above the first vertical position.

10. The heat flow control device according to any one of claims 1 to 9, wherein further comprising a lower protective layer (120) disposed on said lower surface of the heat flow control body (110), and
a plurality of first connecting members (112) disposed on the lower protective layer (120) of the heat flow control body (110).

11. The heat flow control device according to claim 10, wherein the lower protective layer (120) is a solder resist, and
wherein the first connecting members (112) are solder balls.

12. The heat flow control device according to any one of claims 1 to 11, wherein the heat flow control body (110) comprises an uneven portion (110R) on an upper surface thereof,
wherein an average roughness (Ra) of the upper surface of the heat flow control body (110) in the uneven portion (110R) is greater than that of a side surface of the heat flow control body (110S).

13. The heat flow control device according to any one of claims 1 to 12, wherein the average roughness (Ra) of at least a portion of the upper surface of the heat flow control body (110) is in the range of 0.05 µm to 0.8 µm, preferably in the range of 0.1 µm to 0.5 µm.

14. A semiconductor package, comprising:
a first semiconductor device (211) disposed on a first package substrate (210a);
a heat flow control device (101, 102) disposed above the first semiconductor device (210a); and
a second semiconductor device (212) disposed spaced apart from of the first heat flow control device (101, 102) at a lateral side of the first heat flow control device (101, 102);
wherein the heat flow control device (101, 102) is a heat flow control device of any one of claims 1 to 13.

15. A semiconductor module including the semiconductor package according to claim 14.
